(19) Europäisches Patentamt / European Patent Office / Office européen des brevets

(11) **EP 1 476 890 B1**

(12) **EUROPÄISCHE PATENTSCHRIFT**

(45) Veröffentlichungstag und Bekanntmachung des Hinweises auf die Patenterteilung:
**24.09.2014 Patentblatt 2014/39**

(21) Anmeldenummer: **03739497.0**

(22) Anmeldetag: **17.02.2003**

(51) Int Cl.:
*H01J 37/09* *(2006.01)*     *H01J 37/26* *(2006.01)*

(86) Internationale Anmeldenummer:
**PCT/EP2003/001587**

(87) Internationale Veröffentlichungsnummer:
**WO 2003/068399 (21.08.2003 Gazette 2003/34)**

(54) **PHASENPLATTE FÜR DIE ELEKTRONENMIKROSKOPIE UND ELEKTRONENMIK ROSKOPISCHE BILDGEBUNG**

PHASE PLATE FOR ELECTRON MICROSCOPY AND ELECTRON MICROSCOPIC IMAGING

LAME DE PHASE POUR LA MICROSCOPIE ELECTRONIQUE ET IMAGERIE PAR MICROSCOPIE ELECTRONIQUE

(84) Benannte Vertragsstaaten:
**AT BE BG CH CY CZ DE DK EE ES FI FR GB GR HU IE IT LI LU MC NL PT SE SI SK TR**

(30) Priorität: **18.02.2002 DE 10206703**

(43) Veröffentlichungstag der Anmeldung:
**17.11.2004 Patentblatt 2004/47**

(73) Patentinhaber: **Max-Planck-Gesellschaft zur Förderung
der Wissenschaften e.V.
80539 München (DE)**

(72) Erfinder:
• **MAJOROVITS, Endre
69115 Heidelberg (DE)**
• **SCHRÖDER, Rasmus, R.
69118 Heidelberg (DE)**

(74) Vertreter: **Hertz, Oliver
v. Bezold & Partner
Patentanwälte
Akademiestrasse 7
80799 München (DE)**

(56) Entgegenhaltungen:
**EP-A- 0 782 170     EP-A- 1 329 936
US-A- 3 996 468**

• **TOCHIGI H ET AL: "THE IMPROVEMENT OF THE IMAGE CONTRAST BY USING THE PHASE PLATE IN THE TRANSMISSION ELECTRO MICROSCOPE" MICROSCOPIE ELECTRONIQUE, XX, XX, Bd. 1, 30. August 1970 (1970-08-30), Seiten 73-74, XP002054178**
• **MATSUMOTO T ET AL: "THE PHASE CONSTANCY OF ELECTRON WAVES TRAVELING THROUGH BOERSCH'S ELECTROSTATIC PHASE PLATE" ULTRAMICROSCOPY, AMSTERDAM, NL, Bd. 63, Nr. 1, 1. April 1996 (1996-04-01), Seiten 5-10, XP002054177 ISSN: 0304-3991 in der Anmeldung erwähnt**

**Beschreibung**

Die Erfindung betrifft eine Phasenplatte, insbesondere für ein Elektronenmikroskop, mit den Merkmalen gemäß dem Oberbegriff von Anspruch 1, ein mit einer derartigen Phasenplatte ausgestattetes Elektronenmikroskop und ein Verfahren zur elektronenmikroskopischen Bildgebung unter Verwendung eines derartigen Elektronenmikroskops.

Die Phasenkontrastmikroskopie ist ein allgemein bekanntes mikroskopisches Verfahren zur Abbildung von Proben, die einen größeren Einfluss auf die Phase als auf die Amplitude einer Beleuchtungsstrahlung haben. Die Proben, die auch als Phasenobjekte bezeichnet werden, sind semitransparent. Durch Wechselwirkung des Probenmaterials mit der Beleuchtungsstrahlung wird die Phase der Beleuchtungsstrahlung beeinflusst. In der optischen Mikroskopie (Beleuchtungsstrahlung: Licht) ist die Phasenkontrastmikroskopie ein etabliertes Abbildungsverfahren. Mit einem Phasenring, der in der hinteren Brennebene des Objektivs eines Lichtmikroskops angeordnet ist, wird die von der Probe kommende Strahlung nullter Beugungsordnung um 90° phasenverschoben. Die Interferenz der höheren Beugungsordnungen mit dem phasenverschobenen Hauptmaximum liefert das gewünschte kontrastreiche Bild.

Die Phasenkontrastmikroskopie wurde auch für die Elektronenmikroskopie (Beleuchtungsstrahlung: Elektronenwellen) vorgeschlagen. Insbesondere beim Transmissionselektronenmikroskop (TEM), bei dem Proben mit Elektronen durchstrahlt und die Elektronen nach Durchgang durch die Probe elektronenoptisch abgebildet werden, besteht ein Interesse an Phasenkontrastverfahren, da notwendigerweise dünne Proben untersucht werden, die sich durch eine geringe Phasenverschiebung auszeichnen (sog. schwache Phasenobjekte).

Grundprinzipien der elektronenmikroskopischen Phasenkontrastverfahren werden bspw. von S. Zemlin in "Cryst. Res. Technol.", Bd. 33, 1998, S. 1097-1111 erläutert. Im Folgenden werden Einzelheiten der wellenoptischen Beschreibung der Phasenkontrast-Elektronenmikroskopie zur Illustration genannt. Weitere Erläuterungen der Wellenoptik und der Vektordarstellung des Phasenkontrastes ergeben sich insbesondere aus den hier angeführten Veröffentlichungen und Lehrbüchern der Elektronenmikroskopie.

Das mit dem strahlenoptischen System eines Elektronenmikroskops in der Bildebene erzeugte vergrößerte Bild der Probe ergibt sich durch Interferenz von Elektronen, die einerseits an der Probe gebeugt werden und andererseits die Probe ungebeugt durchsetzen. Die Eigenschaften des Interferenzbildes können mit der Phasenkontrastübertragungsfunktion (Phase Contrast Transfer Function, PCTF) beschrieben werden. Die PCTF gibt an, welche Ortsfrequenzen der Probe aufgrund der instrumentellen Eigenschaften in welchem Maße von der Probe in das Bild übertragen werden. Für ein herkömmliches TEM mit Hellfeldabbildung ist die PCTF in erster Näherung eine Sinusfunktion gemäß

$$\mathrm{PCTF}(k) = 2\,\sin(\gamma(k))$$

wobei k der Absolutbetrag des Wellenvektors (Ortsfrequenz) ist. Das Argument der Sinusfunktion ist die Wellenaberration, die nicht-linear von k abhängt:

$$\gamma(k) = \pi/2\;(C_S\lambda^3 k^4 - 2\Delta z\;\lambda k^2)$$

wobei $C_S$ der sphärische Aberrationskoeffizient, $\lambda$ die Elektronenwellenlänge und $\Delta z$ der Defokuswert sind.

Die Ortsfrequenzabhängigkeit zeigt, dass niedrige Ortsfrequenzen (große Strukturen) im Bild wenig oder gar nicht aufgezeichnet werden. Daher erscheint das abgebildete Objekt fast transparent. Der Kontrastübergang verschwindet völlig in einem TEM ohne Linsenfehler ($C_S$ = 0 mm) und für eine Bildaufnahme im Gaussfokus ($\Delta z$ = 0 mm).

Um dennoch Kontraste darzustellen, werden gemäß einer herkömmlichen Technik eine nicht-vollständige Korrektur der Aberration und eine kleine Defokussierung eingestellt, was jedoch zu einem Informationsverlust durch eine Kontrastdelokalisierung führt.

Ein echtes Phasenkontrastverfahren beruht auf der Einführung einer Phasenplatte in die hintere Brennebene der Objektivlinse des Elektronenmikroskops. Die Phasenplatte ist allgemein eine Vorrichtung, die bewirkt, dass zwischen dem gestreuten Wellenanteil und dem ungestreuten Wellenanteil eine zusätzliche Phasenverschiebung eingeführt wird. Beträgt diese 90°, so wird die PCTF in eine Kosinusfunktion gemäß

$$\mathrm{PCTF}_{\pi/2}(k) = 2\cos(\gamma(k))$$

überführt. Mit dieser PCTF kann auch unter optimalen optischen Bedingungen (vollständige Aberrationskorrektur, keine Defokussierung) eine vollständige Kontrastübertragung erfolgen. Es wird die maximale Bildinformation erzielt.

Ein generelles Problem der herkömmlichen Phasenkontrastverfahren besteht in der Einführung der Phasenplatte in den elektronenoptischen Strahlengang. Im Unterschied zum Einsatz eines Phasenringes bei der Lichtmikroskopie sind zusätzliche Einbauten bei der Elektronenmikroskopie in der Regel mit unerwünschten Signalverlusten oder Bildstörungen verbunden.

Aus DE-OS 101 14 949 ist eine Dünnfilmphasenplatte für ein Phasenkontrastmikroskop bekannt. Die Dünnfilmphasenplatte besteht aus einem Dünnfilm, bspw. aus amorphem Kohlenstoff, der an einer Blendenhalterung in der hinteren Brennebene des Objektivs angeordnet ist. Der Dünnfilm enthält eine Durchtrittsöffnung, durch die ungestreute Elektronenwellen ungehindert hindurchtreten. Die von der Probe gestreuten Elektronenwellen hingegen werden durch die Elektronen-Materie-Wechselwirkung im Dünnfilm phasenverschoben. Die herkömmliche Dünnfilmphasenplatte besitzt mehrere Nachteile. Erstens wird mit dem Dünnfilm Materie in den elektronenoptischen Strahlengang gebracht, was zu unerwünschten Effekten bei der Bildgebung führt. Beispielsweise können am Dünnfilm nach Kontamination mit Verunreinigungen aus dem Elektronenmikroskop Aufladungserscheinungen auftreten, die unkontrollierte Phasenverschiebungen und Bildverzerrungen bewirken. Dies wirkt sich besonders nachteilig bei Abbildungen mit hoher Auflösung aus, da die stark gebeugten Elektronenwellen besonders stark beeinflusst werden. Es ergibt sich eine Verminderung des Auflösungsvermögens. Zweitens ist die Dünnfilmphasenplatte nachteilig, wenn mit einem Mikroskop zwischen einer herkömmlichen Hellfeldabbildung und der Phasenkontrastabbildung gewechselt werden soll. Für die Hellfeldabbildung muss die Dünnfilmphasenplatte aus dem Elektronenmikroskop entfernt werden.

Im Unterschied zur Einführung einer Phasenverschiebung durch Elektronen-Materie-Wechselwirkung wird bei der sog. Boersch-Phasenplatte der gewünschte Teil des Elektronenstrahls einem elektrischen Potential ausgesetzt. Je nach Stärke des Potentials wird in den Elektronenwellen eine verschieden starke Phasenverschiebung bewirkt. Eine herkömmliche Boersch-Phasenplatte, wie sie bspw. in EP 782 170 beschrieben wird, ist schematisch in Fig. 9 gezeigt. Die herkömmliche Phasenplatte 10' umfasst eine Ringelektrode 20' und eine Halterungseinrichtung 30'. Die Ringelektrode 20' besteht aus einer ringförmigen Platte 21' mit einer zentralen Öffnung 22' und einem äußeren Rand 23'. Die Halterungseinrichtung 30' wird durch zwei gerade Träger 31', 32' gebildet, die an einander gegenüberliegenden Seiten des Randes 23' angebracht sind und zu einem Teil des elektronenoptischen Systems führen. Mit der herkömmlichen Phasenplatte 10' durchsetzen die an der Probe ungebeugten Elektronen die zentrale Öffnung 22', während die gebeugten Elektronen außerhalb der Platte 21' verlaufen. In der Öffnung 22' ist ein Potential gebildet, mit dem die Phasenverschiebung der Elektronen eingestellt wird.

Die Boersch-Phasenplatte, insbesondere gemäß EP 782 170, besitzt zwar bestimmte Vorteile. So kann die Phasenverschiebung durch eine von außen auf die Ringelektrode aufgeprägte Spannung definiert eingestellt werden. Das Potential in der zentralen Öffnung 22' besitzt eine hohe Homogenität (siehe T. Matsumoto et al. in "Ultramicroscopy", Bd. 63, 1996, S. 5-10). Damit ermöglicht die Boersch-Phasenplatte eine hohe Abbildungsqualität. Die Phasenverschiebung kann durch Abschalten des Potentials abgestellt werden, so dass ein einfaches Umschalten zwischen Hellfeld- und Phasenkontrastverfahren ermöglicht wird.

Die herkömmliche Phasenplatte besitzt jedoch auch einen erheblichen Nachteil. Die Positionierung der Phasenplatte in der hinteren Brennebene des Objektivs bewirkt eine Abschirmung eines erheblichen Teils der gestreuten Elektronen. Die Träger 31', 32' müssen aus Stabilitätsgründen eine gewisse Breite im $\mu$m-Bereich besitzen, die mit der Dimension der Ringelektrode vergleichbar ist. Es kommt zu einem echten Informationsverlust, da die von den Trägern abgeschirmten Teilstrahlen nicht mehr zur Interferenz mit den ungebeugten Elektronen und damit zur Erzeugung der vergrößerten Abbildung der Probe beitragen können. Der Informationsgehalt der herkömmlich mit dem Phasenkontrastverfahren erhaltenen Bilder ist daher beschränkt. Dies ist insbesondere bei unregelmäßigen Proben, wie z. B. Proben aus biologischen Materialien nachteilig.

Die US 3,996,468 beschreibt ein Elektronenmikroskop mit einer kreisförmigen Objektivlinsenblende zur Beseitigung chromatischer Aberation und inaktiver sphärischer Aberation, sowie ein Verfahren zum Herstellen der kreisförmigen Objektivlinsenblende.

Die Aufgabe der Erfindung ist es, eine verbesserte Phasenplatte, insbesondere für ein Elektronenmikroskop bereitzustellen, mit der die Nachteile herkömmlicher Phasenplatten überwunden werden. Die Phasenplatte soll insbesondere einerseits eine hohe Abbildungsqualität und Steuerbarkeit der Phasenverschiebung gewährleisten und andererseits die Bildgebung mit einem erhöhten Informationsgehalt ermöglichen. Eine Aufgabe der Erfindung ist es auch, ein mit einer derart verbesserten Phasenplatte ausgestattetes Elektronenmikroskop bereitzustellen. Eine weitere Aufgabe der Erfindung besteht in der Bereitstellung eines verbesserten Verfahrens zur elektronenmikroskopischen Bildgebung, das sich durch einen erhöhten Informationsgehalt elektronenoptischer Abbildungen auszeichnet.

Diese Aufgaben werden mit einer Phasenplatte, einem Elektronenmikroskop und einem Bildgebungsverfahren mit den Merkmalen entsprechend den Patentansprüchen 1, 8 und 10 gelöst. Vorteilhafte Ausführungsformen und Anwendungen der Erfindung ergeben sich aus den abhängigen Ansprüchen.

Die Grundidee der Erfindung ist es, eine Phasenplatte, insbesondere für ein Elektronenmikroskop mit einer Ringelektrode und einer Halterungseinrichtung bereitzustellen, bei der die Halterungseinrichtung aus mindestens einem nicht-zentralsymmetrisch am äußeren Rand der Ringelektrode angebrachten Träger besteht. Der mindestens eine Träger ist so am Rand angeordnet, dass sich in Bezug auf eine Öffnung in der Ringelektrode am gegenüberliegenden Rand kein weiterer Träger befindet. Gegenüber jedem Träger einer erfindungsgemäßen Phasenplatte ist der Rand der Ringelektrode frei verlaufend. Die Öffnung ist vorzugsweise in der Mitte der Ringelektrode zentral angeordnet. In diesem Fall ist der mindestens eine Träger so am Rand angeordnet, dass sich in Bezug auf die Mitte der Ringelektrode am gegenüberliegenden Rand kein weiterer Träger befindet.

Mit dem mindestens einen Träger erfolgt zwar in der hinteren Brennebene des Objektivs eine Abschattung eines Teilbereichs der gebeugten Elektronenwelle. Durch die nicht-zentralsymmetrische Anbringung der Träger bleibt jedoch im Unterschied zur herkömmlichen Phasenplatte die Elektronenwelle in einem weiteren Teilbereich, der zum abgeschatteten Teilbereich zentralsymmetrisch ist, unbeeinflusst. Aufgrund von Symmetriebeziehungen, die in weiteren Einzelheiten unten erläutert werden, ermöglicht die erfindungsgemäße Phasenplatte vorteilhafterweise eine Rekonstruktion der zunächst durch die trägerbedingte Abschattung verlorengegangene Bildinformation.

Allgemein werden Figuren als zentralsymmetrisch bezeichnet, deren Punkte durch eine ebene Drehung von 180° um einen Punkt zur Deckung gebracht werden können. Bei einer erfindungsgemäßen Phasenplatte ist die Halterungseinrichtung nicht-zentralsymmetrisch. Einzelne Träger können durch eine 180°-Drehung um die Mitte der Phasenplatte oder die optische Achse des Elektronenmikroskops nicht miteinander in Deckung gebracht werden. Die Mitte der Phasenplatte oder der Schnittpunkt der optischen Achse mit der ebenen Phasenplatte heißt auch Symmetriezentrum oder Zentralpunkt.

Gemäß einer ersten Ausführungsform der Erfindung besteht die Halterungseinrichtung aus einem einzigen Träger, der stab- oder stegförmig von der Ringelektrode abstehend an deren Rand angeordnet ist. Bei dieser Gestaltung ist eine Zentralsymmetrie ausgeschlossen, da kein weiterer Träger vorhanden ist. Die Verwendung eines einzelnen Trägers besitzt den Vorteil einer geringen Abschattung von Elektronenwellen und damit eines geringen Aufwandes bei der Rekonstruktion von Bildinformationen.

Gemäß einer weiteren, bevorzugten Ausführungsform der Erfindung besteht die Halterungseinrichtung aus mehreren Trägern, die stab- oder stegförmig radial vom Rand der Ringelektrode abstehen und in verschiedene Richtungen weisen. Diese Gestaltung besitzt den Vorteil einer erhöhten Stabilität der Position der Ringelektrode. Wenn mehrere Träger vorgesehen sind, so ist die Bildung einer n-zähligen Symmetrie (n: ungerade natürliche Zahl) bevorzugt, da dies eine optimale Stabilisierung der Phasenplatte, eine verbesserte Abbildungsqualität und ggf. eine Verminderung der Trägerbreite ermöglicht. Alternativ kann eine gerade Zahl von Trägern vorgesehen sein.

Ein Gegenstand der Erfindung ist auch ein Elektronenmikroskop, das mit der erfindungsgemäßen Phasenplatte ausgestattet ist, die nicht-zentralsymmetrisch gehaltert ist, oder die Verwendung der erfindungsgemäßen Phasenplatte in einem Elektronenmikroskop. Das erfindungsgemäße Elektronenmikroskop besitzt den besonderen Vorteil einer erhöhten Abbildungsqualität und eines erweiterten Anwendungsbereichs. Es ist insbesondere problemlos zwischen Hellfeld- und Phasenkontrastverfahren umschaltbar.

Ein weiterer Gegenstand der Erfindung ist ein Verfahren zur elektronenmikroskopischen Bildgebung, insbesondere unter Verwendung der Phasenplatte oder des Elektronenmikroskops gemäß der Erfindung. Bei der Bildgebung erfolgt eine Rekonstruktion von Bildinformationen, die durch die trägerbedingte Abschattung von Elektronenwellen verloren gegangen sind, unter Verwendung der sog. Friedel-Symmetrie im Bereich der hinteren Brennebene des Mikroskopobjektivs, was in weiteren Einzelheiten unten erläutert wird. Der besondere Vorteil des Verfahrens besteht im erhöhten Informationsgehalt der ermittelten Bilder. Gemäß einer bevorzugten Ausführungsform der Erfindung zeichnet sich das Verfahren durch eine Bildverarbeitung aus, bei der Bildinformationen rekonstruiert werden.

Weitere Vorteile und Einzelheiten der Erfindung werden im Folgenden unter Bezug auf die beigefügten Zeichnungen beschrieben. Es zeigen:

Figuren 1 bis 3:  verschiedene Ausführungsformen erfindungsgemäßer Phasenplatten,

Figur 4:  eine schematische Schnittteilansicht einer erfindungsgemäßen Phasenplatte,

Figur 5:  eine schematische Illustration eines erfindungsgemäßen Elektronenmikroskops,

Figur 6:  Beispiele zur Illustration der erfindungsgemäßen Bildgebung,

Figuren 7, 8:  Flussdiagramme zur Illustration einzelner Schritte der erfindungsgemäßen Bildgebung, und

Figur 9:  eine herkömmlichen Phasenplatte (Stand der Technik).

Im folgenden werden zuerst Ausführungsbeispiele der Erfindung, anschießend deren Funktionsweise und schließlich Merkmale der erfindungsgemäßen Bildgebung erläutert.

1. Ausführungsbeispiele

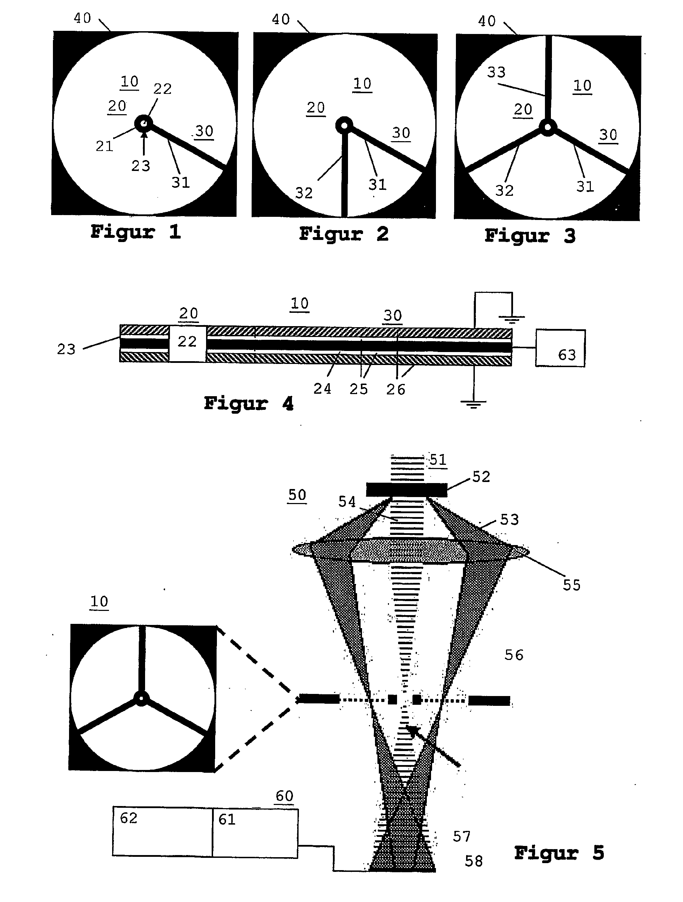

Eine erfindungsgemäße Phasenplatte 10 besteht entsprechend den beispielhaften Darstellungen in den Figuren 1 bis 3 aus einer Ringelektrode 20 und einer Halterungseinrichtung 30. Die Ringelektrode 20 ist eine ringförmige Platte 21 mit einer zentralen Öffnung 22 und einem äußeren umlaufenden Rand 23. Die Platte 21 besitzt eine ebene Gestalt. Die Öffnung 22 und der äußere Rand 23 sind vorzugsweise kreisrund, können aber alternativ von der Kreisform abweichend geformt sein. Die Öffnung 22 befindet sich vorzugsweise in der Mitte der Platte 21. Die Ringelektrode 20 enthält mindestens einen elektrischen Leiter, der zur Bildung eines Phasenverschiebungspotentials durch Beaufschlagung mit einer äußeren Spannung eingerichtet ist.

Die Halterungseinrichtung 30 besteht aus mindestens einem Träger 31, der am äußeren Rand 23 der Ringelektrode 20 befestigt ist. Der Träger 31 dient der Befestigung der Ringelektrode 20 an einem Teil des elektronenoptischen Systems. Die Befestigung erfolgt vorzugsweise an einem Rahmen 40, mit dem die Phasenplatte 10 in eine Blendenhalterung eines Elektronenmikroskops einsetzbar ist. Der Rahmen 40 kann als Teil der Phasenplatte 10 aufgefasst werden.

Der mindestens eine Träger 31 ist allgemein ein starres Bauteil, das quer zur Strahlrichtung, die bei den Figuren 1 bis 3 senkrecht zur Zeichenebene verläuft, eine möglichst geringe Querschnittsfläche und in Strahlrichtung eine möglichst geringe Dicke besitzt. Der Träger besitzt vorzugsweise eine Stab-, Steg- oder Streifenform und wird auch als Haltesteg oder Haltestrebe bezeichnet.

Ein wesentliches Merkmal der Erfindung besteht in der nicht-zentralsymmetrischen Ausrichtung des mindestens einen Trägers 31 der Halterungseinrichtung 30. Der relativ zur Mitte der zentralen Öffnung 22 gegenüberliegende Rand verläuft frei ohne einen weiteren Träger. Träger können nicht durch 180°-Drehungen um die optische Achse miteinander zur Deckung gebracht werden. Damit bleibt der zu einem Träger gegenüberliegende Teilbereich des optischen Strahlengangs am Ort der Phasenplatte frei von abschirmender Materie. Die in diesem freien Teilbereich übertragenen Informationen werden entsprechend den unten erläuterten Prinzipien zur Rekonstruktion der durch den Träger abgeschatteten Informationen verwendet.

Fig. 1 illustriert die Gestaltung mit einem einzelnen Träger 31, mit dem die Ringelektrode 20 am Rahmen 40 befestigt ist. Insbesondere zur Stabilitätserhöhung können alternativ zwei oder mehr Träger 31, 32 vorgesehen sein, wie dies beispielhaft in Fig. 2 illustriert ist. Alle Trägerpaare können jeden Winkel aufspannen, der ungleich 180° ist. Die Träger bilden vorzugsweise eine n-zählige Symmetrie, wobei n eine ungerade natürliche Zahl ist. Fig. 3 illustriert beispielhaft eine 3-zählige Symmetrie mit drei gleichmäßig verteilt, radial abstehenden Trägern 31, 32, 33.

Mindestens ein Träger 31 enthält einen elektrischen Leiter zur Verbindung des elektrischen Leiters der Ringelektrode 20 mit einer äußeren Spannungsquelle. Der Leiter kann alternativ in jedem Träger einer Halterungseinrichtung 30 vorgesehen sein.

Allgemein besitzt die Phasenplatte 10 einen mehrschichtigen Aufbau (siehe Fig. 4) mit dem elektrischen Leiter 24, der beidseitig mit einer Isolationschicht 25 bedeckt ist, die beidseitig eine elektrisch leitfähige Abschirmschicht 26 trägt. Der elektrische Leiter 24 ist mit einer äußeren Spannungsquelle 63 verbunden. Die Abschirmschichten 26 sind mit Massepotential verbunden und dienen der Ableitung von elektrischen Ladungen, die sich beim Betrieb des Elektronenmikroskops auf der Phasenplatte 20 sammeln.

Vorzugsweise ist die Phasenplatte aufgebaut, wie es in EP 0 782 170 beschrieben ist.

Alternativ zum in Fig. 4 gezeigten Sandwich-Aufbau kann der elektrische Leiter in einem Koaxialaufbau wie in einem abgeschirmten Kabel geführt werden.

Die Herstellung und Dimensionierung der erfindungsgemäßen Phasenplatte erfolgt je nach Bauform des Elektronenmikroskops mit an sich bekannten Prozeduren. Der elektrische Leiter 24 und die Abschirmschichten 26 bestehen bspw. aus Gold Die Isolationsschichten 25 bestehen bspw. aus einer Oxidverbindung. Die Dicke des Schichtaufbaus aus elektrischem Leiter und Isolations- und Abschirmschichten beträgt bspw. 1 $\mu$m. Der äußere Durchmesser der Platte 21 beträgt bspw. 3 $\mu$m. Der Durchmesser der zentralen Öffnung 32 und die Breite der geraden Träger betragen bspw. 1 $\mu$m.

Fig. 5 zeigt schematisch eine Ausführungsform eines erfindungsgemäßen Elektronenmikroskops 50, das mit der oben beschriebenen Phasenplatte 10 ausgestattet ist. Das Elektronenmikroskop 50 umfasst eine Elektronenquelle mit einer Kondensorlinse (nicht dargestellt) zur Erzeugung eines Elektronenstrahls 51. Der Elektronenstrahl 51 ist auf eine Probe 52 gerichtet, von der gebeugte oder gestreute Elektronen 53 aus der optischen Achse des Elektronenmikroskops 50 abgelenkt und ungebeugte oder ungestreute Teile des Elektronenstrahls 54 (ungebeugter Primärstrahl) entlang der optischen Achse durchgelassen werden. Nach Wechselwirkung des Elektronenstrahls 51 mit der Probe 52 werden die gebeugten und ungebeugten Teile der Elektronenwelle (53, 54) mit der Objektivlinse 55 gesammelt. In der hinteren Brennebene 56 der Objektivlinse 55 ist die erfindungsgemäße Phasenplatte 10 mit der Ringelektrode 20, der Halterungseinrichtung 30 und dem Rahmen 40 angeordnet. Der ungebeugte Primärstrahl 54 wird bei Durchtritt durch die Ringelektrode 20 phasenverschoben. Die gebeugten Teilstrahlen 53 durchlaufen die Brennebene 56 außerhalb der Ringelektrode 20 ohne eine Phasenverschiebung.

In einer zu Bildebene 57 der Objektivlinse 55 konjugierten Bildebene ist eine Detektoreinrichtung 58 angeordnet, die zur Aufnahme eines Intensitätsbildes der Probe eingerichtet ist. Die Detektoreinrichtung umfasst bspw. eine CCD-Kamera, einen photografischen Film oder andere Bildaufnahmeeinrichtungen, wie z. B. sog. imaging plates. Die Detektoreinrichtung 58 ist mit einer Steuereinrichtung 60 verbunden, die eine Bildverarbeitungseinheit 61 und Ausgabe- und Speichereinrichtungen 62 enthält. Die Bildverarbeitungseinrichtung 61 ist zur Durchführung des unten erläuterten Korrekturverfahrens eingerichtet. Die Ausgabe- und Speichereinrichtung 62 enthält bspw. eine Anzeige.

Die Umsetzung der Erfindung ist nicht auf ein Transmissionselektronenmikroskop 50 gemäß Fig. 5 beschränkt. Das Elektronenmikroskop kann einen abgewandelten Aufbau oder zusätzliche elektronenoptische Komponenten enthalten, wie es aus der Transmissionselektronenmikroskopie an sich bekannt ist.

Die Phasenplatte 10 ist senkrecht zur optischen Achse des Elektronenmikroskops 50 in der hinteren Brennebene 56 angeordnet und relativ zur optischen Achse zentriert. Die optische Achse verläuft durch die Mitte der zentralen Öffnung 22 der Ringelektrode 20. Die Positionierung der Phasenplatte 10 im Elektronenmikroskop 50 kann vorteilhafterweise dauerhaft erfolgen, da durch Abschalten des Potentials der Ringelektrode 20 zur Hellfeldmikroskopie übergegangen werden kann, ohne dass ein Verlust an Bildinformationen hingenommen werden muss.

### 2. Elektronenoptische Wirkung der Phasenplatte

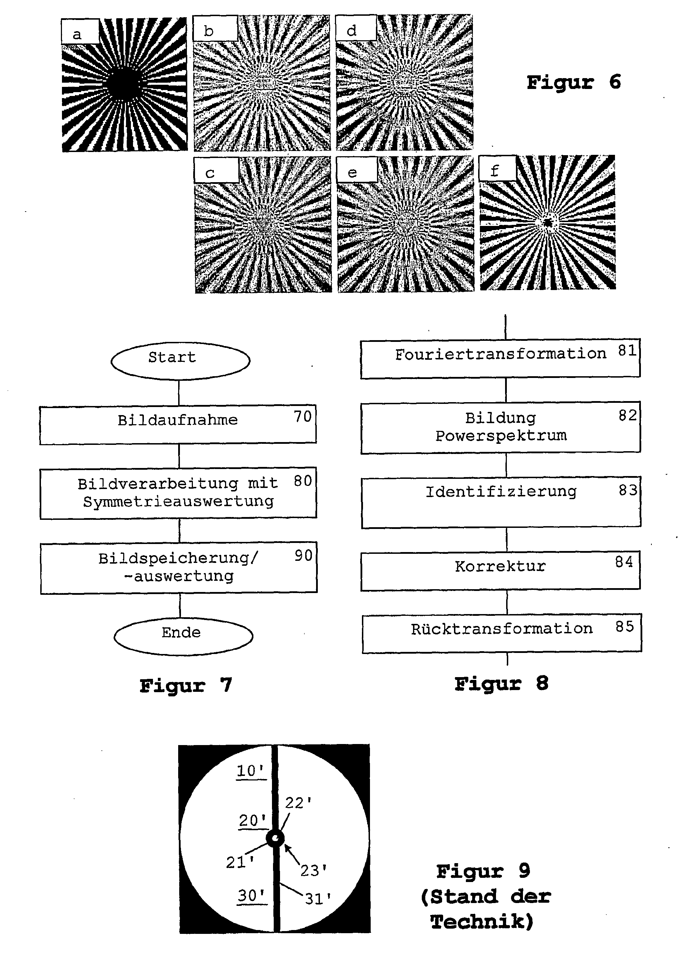

Bei einer Boersch-Phasenplatte wird der ungebeugte Teil der Elektronenwelle unter Wirkung eines elektrischen Potentials phasenverschoben. Das Potential wird mit der Ringelektrode erzeugt, die bei herkömmlichen Phasenplatten mit zentralsymmetrisch angeordneten Trägern (zweizählige Symmetrie, siehe Fig. 9) gehaltert wird. Durch jeden Träger wird ein Teil der Elektronen ausgeblendet, so dass ein Informationsverlust eintritt.

Die folgenden Überlegungen der Erfinder führten zu der Erkenntnis, dass durch die erfindungsgemäß veränderte Trägergeometrie der Informationsverlust rekonstruiert werden kann. Wegen der zentralsymmetrischen Anordnung der Elektronenoptik und der Art der Wechselwirkung zwischen der Probe und den Elektronen, die quantenmechanisch in der Born'schen Näherung beschrieben kann, weist die Diffraktionsebene (hintere Brennebene der Objektivlinse) in erster Näherung eine sog. Friedelsymmetrie auf. Dies bedeutet, dass Punkte der komplexen Wellenfunktion, die relativ zur optischen Achse zentralsymmetrisch gelegen sind, zueinander komplex konjugiert sind. Der Funktionswert auf einer Seite in der Diffraktionsebene entspricht somit bis auf die komplexe Konjugation dem Funktionswert auf der zentralsymmetrisch gegenüberliegenden Seite. Für die Wellenfunktion des Elektrons gilt:

$$\Psi(-k) = \Psi^*(k)$$

Diese komplex konjugierten Funktionswerte werden auch als Friedelpaare bezeichnet.

Bei der herkömmlichen Phasenplatte mit zentralsymmetrisch angeordneten Trägern werden gerade die Informationen entsprechend den Friedelpaaren komplett ausgeblendet (gelöscht). Dieser Informationsverlust ist irreversibel. Die Erfinder haben festgestellt, dass bei einer nicht-zentralsymmetrischen Halterung eine grundlegend andere Situation auftritt. In diesem Fall wird die Information eines Teils des Friedelpaares weiterhin in die Bildebene übertragen. Es kommt zwar zu einer Verminderung des Signal-Rausch-Verhältnisses, jedoch liegt die Bildinformation weiter vor. Die Auslöschung oder Erhaltung von Friedelpaaren ist in Fig. 6 am Beispiel von Simulationsergebnissen gezeigt. Fig. 6 zeigt in Bild a beispielhaft ein Testobjekt in Form eines sog. Siemenssterns. Dieser repräsentiert aufgrund von allseits spitz zulaufenden Streben alle Raumfrequenzen und alle räumlichen Orientierungen. Der Stern dient als "Originalprobe" für die in den Bildern b-f gezeigten Simulationsergebnisse. Die Bilder b und c zeigen herkömmliche Hellfeld-Abbildungen, bei denen eine herkömmliche Phasenplatte (b) mit zwei-zähliger Symmetrie oder eine erfindungsgemäße Phasenplatte (c) mit dreizähliger Symmetrie in der hinteren Brennebene des Objektivs angeordnet sind. Die Bilder d und e sind entsprechende Phasenkontrast-Abbildungen, bei denen die Phasenplatte zur Einführung der erläuterten Phasenverschiebung mit einem Potential beaufschlagt ist. Bild f zeigt die Phasenkontrast-Abbildung e nach einer ergänzenden Korrektur.

Die Bilder zeigen, dass sowohl im Hellfeld- als auch im Phasenkontrast-Modus die herkömmliche Phasenplatte zu einem Informationsverlust entsprechend der Ausrichtung der Träger führt. In den Bilder b und d ist die Auslöschung von Informationen (hier in horizontaler Richtung) erkennbar. Mit der erfindungsgemäßen Phasenplatte hingegen sind die Bildinformationen vollständig erhalten geblieben. Dies ist bereits bei unkorrigierten Bildern (c, e) der Fall. Allerdings zeigen diese noch geringfügige Kontrastschwankungen entsprechend der Ausrichtung der Träger, die in den Bildern aus drucktechnischen Gründen nicht erkennbar sind. Vorteilhafterweise wird die bei den Bildern b und d auftretende Fehlinterpretation der Objektstruktur bei Verwendung der erfindungsgemäßen Phasenplatte vermieden. Wegen der o. g. Beziehung zwischen den Teilen eines Friedelpaares kann die durch einen Träger ausgefilterte Bildinformation aus den Reflexen im zentralsymmetrisch zum Träger liegenden Teilbereich des Elektronenwellenfeldes rekonstruiert werden.

Durch eine Gewichtung der Raumfrequenzen entsprechend der Geometrie der Phasenplatte kann die Rekonstruktion der ausgeblendeten Bildinformation verbessert werden. Dies ist im Teilbild f gezeigt und wird in weiterer Einzelheiten unten erläutert.

3. Bildgebung

Fig. 6e zeigt, dass ein mit der erfindungsgemäßen Phasenplatte aufgenommenes Bild die rekonstruierten Bildinformationen enthält. Die Rekonstruktion erfolgt automatisch bei der Interferenz von gebeugten und nichtgebeugten Elektronenwellen. Eine Bearbeitung der mit der Detektoreinrichtung 58 erhaltenen Bilder ist somit nicht zwingend erforderlich. Gemäß einer ersten Ausführungsform der Erfindung ist das Verfahren zur elektronenmikroskopischen Bildgebung auf die Abbildung mit der erfindungsgemäßen Phasenplatte ohne eine weitere Bildverarbeitung gerichtet.

Gemäß einer weiteren Ausführungsform kann für eine weitere Erhöhung der Bildqualität eine Bildverarbeitung vorgesehen sein, die im Folgenden unter Bezug auf die Figuren 7 und 8 erläutert wird. Allgemein umfasst diese Ausführungsform der Bildgebung mit verbesserter Rekonstruktion gemäß Fig. 7 die Schritte Bildaufnahme 70, Bildbearbeitung 80 und Bildspeicherung und/oder -auswertung 90. Die Schritte 70 und 90 sind an sich bekannt. Die Bildaufnahme 70 umfasst den üblichen Betrieb des Elektronenmikroskops 50. Hierbei wird der Hellfeld- oder der Phasenkontrastbetrieb eingeschlossen. Die erfindungsgemäße Bildgebung kann auch zur Bildkorrektur im Hellfeldbetrieb vorgesehen sein. Die Bildspeicherung und/oder -auswertung 90 umfasst je nach Anwendungsfall weitere Schritte der Bildverarbeitung.

Einzelheiten der Bildbearbeitung 80 sind in Fig. 8 dargestellt. Bei Schritt 81 wird das mit der Detektoreinrichtung 58 gewonnene Bild der Probe einer Fouriertransformation unterzogen. Aus dem transformierten Bild wird bei Schritt 82 das zweidimensionale Powerspektrum gebildet. Ein Powerspektrum ergibt sich aus den Amplitudenquadraten des Fourier-transformierten Objektbildes. Das ideale Powerspektrum des Originals zeigt Maxima entsprechend den in der Probe enthaltenen Ortsfrequenzen. Beim o. g. Testobjekt treten alle Ortsfrequenzen im Powerspektrum auf. Bei Schritt 83 werden die Teilbereiche im Powerspektrum, die den Abschattungen durch die Träger der Phasenplatte entsprechen, identifiziert. Vorteilhafterweise ist die Form der Phasenplatte im Powerspektrum als Schattenbild mit verminderten Amplitudenwerten zu erkennen. Wegen der Symmetrisierung der Wellenfunktion ist das Schattenbild auch bei der erfindungsgemäßen Phasenplatte zentralsymmetrisch. Allerdings enthält es die gesamte Bildinformationen und gibt genau die Position der zu korrigierenden Ortsfrequenzen an.

Bei der folgenden Korrektur 84 werden die Amplitudenwerte im Powerspektrum entsprechend den zu korrigierenden Ortsfrequenzen korrigiert. Die Korrektur umfasst eine Wichtung der Amplitudenwerte der Fourier-Transformierten des Bildes. Beispielsweise werden die Amplitudenwerte entlang der trägerbedingten Schatten mit 2 multipliziert. Dadurch wird der Informationsverlust weitgehend korrigiert. Im Ergebnis zeigen sich ausgeglichene Bilder (siehe z. B. Fig. 6f). Alternativ ist es möglich, die Korrektur 84 unter Verwendung von Bildinformationen aus einer Hellfeldaufnahme der Probe durchzuführen. Das korrigierte Intensitätsbild der Probe wird durch die Fourier-Rücktransformation 85 der korrigierten Fourier-Transformierten des Bildes gewonnen.

Vorteilhafterweise hat sich gezeigt, dass die erfindungsgemäße Bildgebung nicht nur bei kristallinen Proben sondern auch bei unregelmäßigen Proben, wie z. B. aus biologischen Materialien, hervorragende Ergebnisse liefert.

**Patentansprüche**

1. Phasenplatte (10) für ein Elektronenmikroskop, die umfasst:

   - eine Ringelektrode (20), die als Platte (21) mit einer Öffnung (22) und einem umlaufenden äußeren Rand (23) gebildet ist, und
   - eine Halterungseinrichtung (30), die mindestens einen Träger (31, 32, 33) umfasst, der am äußeren Rand (23) der Ringelektrode (20) angebracht und zur Positionierung der Ringelektrode (20) in einem elektronenoptischen Strahlengang des Elektronenmikroskops vorgesehen ist, wobei
   - die Phasenplatte (10) eine Boersch-Phasenplatte ist und einen mehrschichtigen Aufbau mit einem elektrischen Leiter (24) aufweist, der mit einer Isolationsschicht (25) bedeckt ist, die eine elektrisch leitfähige Abschirmschicht (26) trägt,
   **dadurch gekennzeichnet, dass**
   - die Halterungseinrichtung (30) nicht-zentralsymmetrisch ausgebildet ist und für jeden Träger (31, 32, 33) am relativ zur Mitte der Öffnung (22) gegenüberliegenden äußeren Rand (23) der Platte (21) kein weiterer Träger angeordnet ist.

2. Phasenplatte gemäß Anspruch 1, bei der die Halterungseinrichtung (30) aus einem Träger (31) besteht, der stabförmig gebildet ist und radial von der Platte (21) der Ringelektrode (20) absteht.

7

**3.** Phasenplatte gemäß Anspruch 1, bei der die Halterungseinrichtung (30) aus mehreren Trägern (31, 32, 33) besteht, die stabförmig gebildet sind und radial von der Platte (21) der Ringelektrode (20) abstehen.

**4.** Phasenplatte gemäß Anspruch 3, bei der die stabförmigen Träger (31, 32, 33) eine n-zählige Symmetrie bilden, wobei n eine ungerade natürliche Zahl ist.

**5.** Phasenplatte gemäß einem der vorhergehenden Ansprüche, bei der mindestens ein Träger der Halterungseinrichtung (30) mindestens einen elektrischen Leiter (24) enthält.

**6.** Phasenplatte gemäß einem der vorhergehenden Ansprüche, die mit einem Rahmen (40) ausgestattet ist.

**7.** Phasenplatte gemäß Anspruch 6, bei der der Rahmen (40) zum Einsatz in eine Blendenhalterung eines Elektronenmikroskops eingerichtet ist.

**8.** Elektronenmikroskop (50), das mit einer Phasenplatte (10) gemäß einem der vorhergehenden Ansprüche ausgestattet ist.

**9.** Elektronenmikroskop gemäß Anspruch 8, bei dem die Phasenplatte (10) im elektronenoptischen Strahlengang in der hinteren Brennebene eines Objektivs (55) ortsfest positioniert ist.

**10.** Verfahren zur elektronenmikroskopischen Abbildung einer Probe unter Verwendung eines Elektronenmikroskops gemäß Anspruch 8 oder 9, bei dem ein vergrößertes Bild der Probe mit einer Detektoreinrichtung (58) aufgenommen wird, wobei

- eine Rekonstruktion von Bildinformationen erfolgt, die durch Abschattung des Strahlenganges durch den mindestens einen Träger der Phasenplatte verloren gegangen sind, und wobei
- die Rekonstruktion der Bildinformationen unter Verwendung der Friedelsymmetrie von Elektronenwellen in der hinteren Brennebene des Objektivs (55) erfolgt.

**11.** Verfahren gemäß Anspruch 10, bei dem das vergrößerte Bild einer Bildbearbeitung unterzogen wird, bei der eine Korrektur der rekonstruierten Bildinformationen erfolgt.

**12.** Verfahren gemäß Anspruch 11, bei dem die Bildbearbeitung eine Fouriertransformation des aufgenommenen Bildes, die Bildung eines Powerspektrums und eine Korrektur der Bildinformationen in der Fourier-Transformierten des Bildes umfasst.

**Claims**

**1.** Phase plate (10) for an electron microscope, comprising:

- an annular electrode (20), which is formed as plate (21) with an opening (22) and a circumferential outer edge (23), and
- a support device (30), comprising at least one support (31, 32, 33) which is situated on the outer edge (23) of the annular electrode (20) and provided to position the annular electrode (20) in an electron-optical beam path of the electron microscope, wherein
- the phase plate (10) is a Boersch phase plate and has a multilayer structure with an electrical conductor (24), which is covered with an insulation layer (25), which carries an electrically conductive shielding layer (26), **characterised in that**
- the support device (30) is formed so that it is not centrally symmetric and that no further support is arranged for each support (31, 32, 33) on the opposite outer edge (23) of the plate (21) relative to the center of the opening (22).

**2.** Phase plate according to Claim 1, wherein the support device (30) consists of one support (31) which is rod-shaped and which radially protrudes from the plate (21) of the annular electrode (20).

**3.** Phase plate according to claim 1, wherein the support device (30) consists of several supports (31, 32, 33), which are rod-shaped and which radially protrude from the plate (21) of the annular electrode (20).

**4.** Phase plate according to claim 3, wherein the rod-shaped supports (31, 32, 33) form an n-fold symmetry, in which n is an odd natural number.

**5.** Phase plate according to any one of the preceding claims, wherein at least one support of the support device (30) includes at least one electrical conductor (24).

**6.** Phase plate according to any one of the preceding claims, which is provided with a frame (40).

**7.** Phase plate according to claim 6, wherein the frame (40) is adapted for use in an aperture support on an electron microscope.

**8.** Electron microscope (50), which is provided with a phase plate (10) according to one of the preceding claims.

**9.** Electron microscope according to claim 8, wherein the phase plate (10) is permanently positioned in the electron-optical beam path in the rear focal plane of a lens (55).

**10.** Method of electron microscopic imaging of a sample using an electron microscope according to claims 8 or 9, in which a magnified image of the sample is taken using a detector device (58), wherein

- a reconstruction of image information takes place which has been lost due to shadowing of the beam path by the at least one support of the phase plate, and wherein
- the reconstruction of image information takes place using the Friedel symmetry of electron waves in the rear focal plane of the lens (55).

**11.** Method according to claim 10, wherein the magnified image is subjected to image processing in which the reconstructed image information is corrected.

**12.** Method according to claim 11, wherein the image processing comprises a Fourier transformation of the image that has been taken, the formation of a power spectrum and a correction of image information in the Fourier-transformed image.

**Revendications**

**1.** Lame de phase (10) pour un microscope électronique, qui comprend :

- une électrode annulaire (20), qui, en tant que lame (21), est formée par un orifice (22) et une bordure extérieure (23) périphérique, et
- un dispositif de fixation (30), qui comprend au moins un support (31, 32, 33), qui est installé sur la bordure extérieure (23) de l'électrode annulaire (20) et qui est prévu pour positionner l'électrode annulaire (20) dans une trajectoire de faisceau optoélectronique du microscope électronique, sachant
- que la lame de phase (10) est une lame de phase de Boersch et présente une structure multicouche pourvue d'un conducteur (24) électrique, lequel est recouvert d'une couche d'isolation (25), qui supporte une couche de blindage (26) électroconductrice, **caractérisée en ce que**
- le dispositif de fixation (30) est réalisé sans symétrie centrale, et **en ce que** pour chaque support (31, 32, 33) aucun support supplémentaire n'est disposé au niveau de la bordure extérieure (23), opposée par rapport au centre de l'orifice (22), de la lame (21).

**2.** Lame de phase selon la revendication 1, dans le cadre de laquelle le dispositif de fixation (30) est constitué d'un support (31), qui est formé de manière à présenter une forme de barre et qui fait saillie radialement de la lame (21) de l'électrode annulaire (20).

**3.** Lame de phase selon la revendication 1, dans le cadre de laquelle le dispositif de fixation (30) est constitué de plusieurs supports (31, 32, 33), qui sont formés de manière à présenter une forme de barre et qui font saillie radialement de la lame (21) de l'électrode annulaire (20).

**4.** Lame de phase selon la revendication 3, dans le cadre de laquelle les supports (31, 32, 33) présentant une forme de barre forment une symétrie de valeur n, sachant que n est un nombre naturel impair.

**5.** Lame de phase selon l'une quelconque des revendications précédentes, dans le cadre de laquelle au moins un support du dispositif de fixation (30) comporte au moins un conducteur électrique (24).

**6.** Lame de phase selon l'une quelconque des revendications précédentes, laquelle est dotée d'un cadre (40).

**7.** Lame de phase selon la revendication 6, dans le cadre de laquelle le cadre (40) est mis en place pour être inséré dans un système de fixation de diaphragme d'un microscope électronique.

**8.** Microscope électronique (50), qui est doté d'une lame de phase (10) selon l'une quelconque des revendications précédentes.

**9.** Microscope électronique selon la revendication 8, dans le cadre duquel la lame de phase (10) est positionnée de manière stationnaire dans la trajectoire de faisceau optoélectronique, dans le plan focal arrière d'un objectif (55).

**10.** Procédé servant à reproduire par microscopie électronique un échantillon en utilisant un microscope électronique selon la revendication 8 ou 9, dans le cadre duquel, à l'aide d'un dispositif de détection (58), une image agrandie de l'échantillon est enregistrée, sachant

- qu'une reconstruction des informations d'image qui ont été perdues du fait de l'occultation de la trajectoire de faisceau par l'au moins un support de la lame de phase est effectuée, et sachant
- que la reconstruction des informations d'image est effectuée en utilisant la symétrie au sens de la loi de Friedel des ondes électroniques dans le plan focal arrière de l'objectif (55).

**11.** Procédé selon la revendication 10, dans le cadre duquel l'image agrandie est soumise à un traitement d'image, lors duquel une correction des informations d'image reconstruites est effectuée.

**12.** Procédé selon la revendication 11, dans le cadre duquel le traitement d'image comprend une transformation de Fourier de l'image enregistrée, la formation d'un spectre de puissance et une correction des informations d'image dans la transformée de Fourrier de l'image.

**Figur 1**   **Figur 2**   **Figur 3**

**Figur 4**

**Figur 5**

**Figur 6**

```
  ┌──────────┐
  │  Start   │
  └────┬─────┘
       │
┌──────────────────┐
│ Bildaufnahme  70 │
└────────┬─────────┘
         │
┌──────────────────────┐
│ Bildverarbeitung mit 80 │
│   Symmetrieauswertung │
└──────────┬───────────┘
           │
┌──────────────────────┐
│ Bildspeicherung/  90 │
│   -auswertung        │
└──────────┬───────────┘
           │
     ┌──────────┐
     │   Ende   │
     └──────────┘
```

**Figur 7**

```
┌────────────────────────────┐
│ Fouriertransformation  81  │
└─────────────┬──────────────┘
              │
┌────────────────────────────┐
│ Bildung            82      │
│ Powerspektrum              │
└─────────────┬──────────────┘
              │
┌────────────────────────────┐
│ Identifizierung    83      │
└─────────────┬──────────────┘
              │
┌────────────────────────────┐
│ Korrektur          84      │
└─────────────┬──────────────┘
              │
┌────────────────────────────┐
│ Rücktransformation  85     │
└────────────────────────────┘
```

**Figur 8**

**Figur 9**
**(Stand der Technik)**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE OS10114949 A
- EP 782170 A
- US 3996468 A
- EP 0782170 A

**In der Beschreibung aufgeführte Nicht-Patentliteratur**

- **S. ZEMLIN.** *Cryst. Res. Technol.,* 1998, vol. 33, 1097-1111
- **T. MATSUMOTO et al.** *Ultramicroscopy,* 1996, vol. 63, 5-10